Europäisches Patentamt

European Patent Office

Office européen des brevets

(11) Publication number: **0 114 949**
**B1**

(12) EUROPEAN PATENT SPECIFICATION

(45) Date of publication of patent specification: **21.02.90**

(51) Int. Cl.⁵: **G 03 F 1/00**

(21) Application number: **83110967.3**

(22) Date of filing: **03.11.83**

(54) Self-aligning resist mask.

(30) Priority: **30.12.82 US 454899**

(43) Date of publication of application:
**08.08.84 Bulletin 84/32**

(45) Publication of the grant of the patent:
**21.02.90 Bulletin 90/08**

(84) Designated Contracting States:
**AT DE FR GB IT**

(56) References cited:
**DE-B-1 097 149**
**FR-A-2 117 915**
**US-A-4 088 896**

(73) Proprietor: **International Business Machines
Corporation
Old Orchard Road
Armonk, N.Y. 10504 (US)**

(72) Inventor: **Walker, George Alexander
17 Frances Drive
Hopewell Junction, N.Y. 12533 (US)**

(74) Representative: **Kreidler, Eva-Maria, Dr. rer. nat.
Schönaicher Strasse 220
D-7030 Böblingen (DE)**

EP 0 114 949 B1

Courier Press, Leamington Spa, England.

## Description

This invention relates to the construction of improved masks used in the generation of patterns employed in the production of integrated circuits. In particular, this invention relates to a self-aligning mask used in a multi-layer ceramic (MLC) device.

An MLC is a multi-layer ceramic packaging substrate. Numerous layers, in the order of 20—30, are employed, each made of a ceramic material and having an electrically conductive, personalized wiring pattern. The layers are stacked to define within the stack power layers, signal layers, redistribution layers, and the like, all interconnected.

A large number of VLSI chips are mounted on the top of the substrate which in turn establishes all electrical connections to and between those chips. On the top portion of the substrate, each chip site has a central array of contact pads, I/O connections, and the like, surrounded by one or more frames of engineering pads. Such MLC devices are described in greater detail in: A.J. Blodgett and D.R. Barbour-"Thermal Conduction Module: A High-Peformance Multilayer Ceramic Package". IBM Journal of Research and Development, Vol. 26, No. 1, Jan. 1982; G.A. Walker, "Failure Analysis of Multilayer Ceramic Substrates", 18th Annual Proceedings, Reliability Physics, 1980 IEEE Catalog No. 80CH1531—3.

The MLC ceramic is a fired $Al_2O_3$ substrate having on its top layer the above-described features utilizing molybdenum metallization. Following firing, additional metallization is required on the Mo features to provide chip, I/O pin, and flange joining. Currently, metal plating is used to define this metallization. Such plating techniques constitute a major process problem in the fabrication of the complete MLC. Plating may, for example, be extraneous and located where it is not needed. It may bridge between features or conversely not be present and not plate certain features. Bath chemistry and control for accurate plating is complex. For example, thickness control, normally the time in the bath is difficult to accurately replicate. The effect of impurities codeposited both in terms of bulk and surface is a serious problem. Finally, there is a sever environmental impact by the dumping and disposal of used baths. Cost considerations, processing difficulties and the introduction of defects in the product also detract from the overall yield of the final device. Given the extensive processing (many months) needed to reach these final steps, processing which detracts from the overall yield rate must therefore be minimized. Moreover, separate masking steps are not always accurately aligned with the existing metallization so that errors occur in the plating step requiring extensive operator time to correct. Accordingly, there exists a need to define an improved technique for acceptable metallurgical definition following firing of the MLC product.

The prior art is replete with a host of proposals for use in various masks and alignment systems in conjunction withy X-ray lithograpyy techniques. Typical are various systems proposed in United States Patents 3 740 280; 3 742 229; 3 742 230; 3 743 842; 3 767 398; 4 022 927; and 4 035 522. Reference is made to U.S. Patent 4 018 938 defining a method of constructing aligned masks utilizing X-ray illumination through the back side of the substrate. On top of an intermediate product comprising a substrate having a thin plating layer with plated areas, an additional resist is coated over the entire surface. The substrate is then illuminated by X-rays having a wavelength of approximately 0,83 nm (8,3 Å) to expose portions of the second resist which are not protected by the plated areas. Those plated areas modulate the X-ray illumination, i.e., serve as the mask itself to avoid misregistration. The resist is then developed such that the unexposed areas leave holes directly above the plated areas. A second plating operation is then carried out to increase the height of the plated area and both resist layers are removed leaving a final product having suitable high aspect ratio.

Reference is also made to U.S. Patent 4 215 192 which is also directed to X-ray lithography utilizing a mask membrane having absorbers interposed between the X-ray source and a resist coated on top of a substrate for processing. A reduction in exposure time is achieved by utilizing tungsten as a target to permit operation at higher power densities. While offering advantages in terms of processing times, the system does not achieve the necessary self-aligning for use in MLC products having an extensive highly dense array of metallization at the top layers.

The prior art also includes a number of different proposals for resist materials for use in X-ray lithography systems. Typical are various resist processing techniques as set forth in IBM Technical Disclosure Bulletin (TDB), Vol. 18, No. 7, pp. 2344—2347, December 1975; IBM TDB, Vol 19, No. 11, p. 4193, April 1977; Taylor "X-Ray Resist Materials", in Solid State Technology, May 1980, page 73; U.S. Patent 4 061 829; and Haller et al, "High Resolution Positive Resist for Electron Beam Exposure", IBM Journal, pp. 251—256, May 1968.

Accordingly, while the prior art offers a number of X-ray lithography processing techniques and a host of resist materials of choice, there exists a need in this technology to define a process which is self-aligning in the context of a highly complex molybdenum metallization pattern on the top surface of an $Al_2O_3$ ceramic substrate. Such a self-aligning mask would remove a significant processing limitation in eliminating the plating requirement for final metallization in the formulation of a complete MLC.

Given these deficiencies in the prior art, it is an object of this invention to define a method of forming a resist mask over the surface of a dielectric substrate that is self-aligning and eliminates the requirement of subsequent metal plating.

A further object of this invention is to define a process of forming a self-aligned resist mask over an alumina ceramic substrate having a conductive molybdenum pattern at the surface.

These and other objects of this invention are attained by utilizing a method of forming a resist mask over the surface of a dielectric $Al_2O_3$ ceramic substrate having thereon a conductive molybdenum pattern. A blanket coating of an Al X-ray sensitive resist is applied. The substrate is subsequently dosed with X-rays to induce X-ray emission by the aluminum in the substrate. The resist is however unaffected by the X-ray illumination—it is sensitive only to the induced X-ray emission.

At portions where the Mo features exist, very little aluminum X-ray excitation occurs having no resulting effect on the overlying photoresist. Thus, the resist adjacent the surface molybdenum pattern is penetrated by the aluminum X-ray emission and hardened while those areas over the metallization pattern are not so doped. In a known technique, the negative resist is then developed for removal of only those "soft" portions over the molybdenum pattern yet retaining the resist doped by the aluminum X-ray emission. This defines a self-aligned mask for subsequent processing since the Mo features themselves determine the areas which are doped. The mask is therefore suitable for either evaporation or sputter coating, eliminating the requirement of the prior art technique of plating.

This invention will be described in greater detail with reference to the description of the preferred embodiment that follow and the attached drawing, in which:

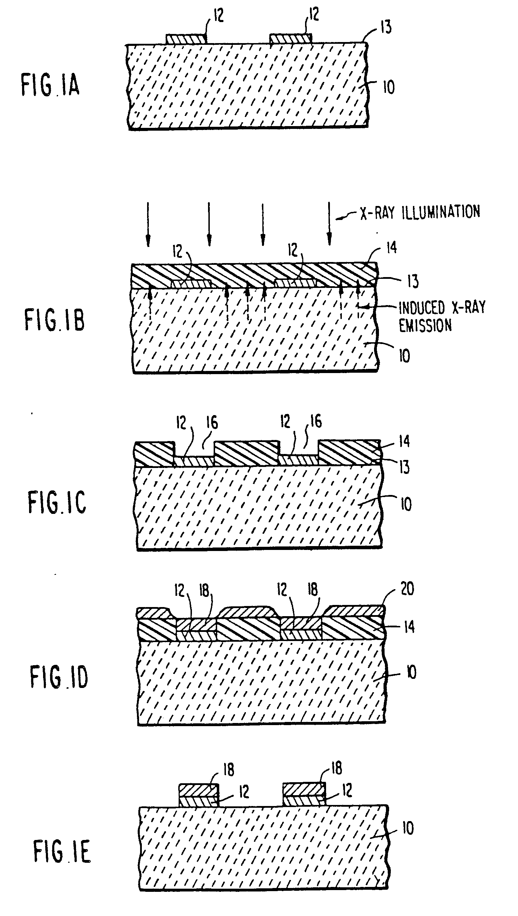

Figs. 1A through 1E inclusive, are cross-sections of the product produced by the process of this invention in various stages of fabrication.

Referring first to Fig. 1A, a cross-section of a portion of a MLC product after firing is depicted. The fired substrate 10 is an $Al_2O_3$ ceramic having thereon molybdenum metallization 12. The patterns 12 formed on the top surface 13 defines various contact points for I/O pins, flange joining, chip connections, engineering change pads and the like. Fig. 1A is highly schematic, showing only several features, eliminating the layering and personalization inherent in an MLC. It will be appreciated that such detail is not required to describe this invention. Additional metal definition is required to define those connections to the Mo metallization 12. The prior art technique of plating has exhibited a number of processing problems as explained herein.

In accordance with the present invention as shown in Fig. 1B, an aluminum X-ray sensitive photoresist 14 is applied over the surface of the MLC. The photoresist is selected from: HC Resist, brominated tetrathiafulvalene-functionalized poly-styrene, metalacrylates, t-1 poly-(methylmethacrylate-co-methacrylic acid) or poly-methylmethacrylate. It covers the substrate surface 13 and the molybdenum metallization 12. The typical thickness of the resist 14 is sufficient to suitably cover yet provide holes of suitable depth for subsequent metallization. That is, the resist 14 is a negative resist such that unexposed areas are removed.

X-ray illumination takes place at suitable energy levels with dosages adjusted to be above the sensitivity of the particular resist employed. The dosage ranges from tens of $mj/cm^2$ to hundreds of $mj/cm^2$ which will not sensitize the photoresist 14 but are capable of exciting Al X-rays from the $Al_2O_3$ substrate. That is, the resist 14 is insensitive to X-ray illumination. It is, however, sensitive to induced X-ray emission by the aluminum of the substrate 12 such that such emissions penetrate the resist in areas not screened by the molybdenum pattern 12.

It is known that,

$$Mo\ K\alpha\ \lambda = 0,7107\ \text{Å}\ (0,07107\ nm)$$

$$Al\ K\alpha\ \lambda = 8,338\ \text{Å}\ (0,8338\ nm)$$

therefore,

$$\Delta\lambda = 7,628\ \text{Å}\ (0,7628\ nm).$$

Consequently, the molybdenum serves to modulate the X-ray emissions by the aluminum such that the metallization pattern itself defines the particular resist pattern which will remain insensitive to the induced aluminum X-ray emissions. As a result of this induced X-ray emission, those portions of the resist 14 which are exposed to aluminum X-ray emission are doped and hardened to impede removal. Conversely, the areas above the Mo are unaffected.

Fig. 1C shows the intermediate product wherein the negative resist 14 has been processed in a known manner to remove it from the top surfaces of the Mo features leaving holes 16 in the pattern 14. Thus, as shown in Fig. 1C, a mask is produced which is self-aligned with the molybdenum metallization. Given the inherent self-aligned nature of the mask, coating by evaporation or sputtering of subsequent metallization can be easily achieved. By use of those techniques, a second level of metallization 18 is deposited into the holes 16 as shown in Fig. 1D. This is an important advantage given the inherent alignment of the mask 14 with the metallization pattern. By using sputter or evaporation techniques, a blanket coating of metal 20 results. However, as shown in Fig. 1E, when the resist 14 is removed, the excess blanket metal coating 20 is also removed leaving a metal layer 18 retained on the molybdenum pattern 12.

Thus, in accordance with the present invention, a method is defined wherein a resist mask is produced over a molybdenum metallization pattern that is self-aligning and requires no intermediate masks itself. The molybdenum defines its own masking pattern which is doped by emissions from the induced aluminum X-ray emission. This technique eliminates the requirement of plating top surfaces of the MLC, heretofore a difficult, expensive, and time-consuming process.

While the invention has been described relative to an $Al_2O_3$ substrate with Mo metallization, it is apparent that the invention can be practiced with other materials so long as the $\Delta\lambda$ is sufficientyl large. In such a case, the resist material will be chosen to be responsive to the particular induced X-rays of the metal component of the ceramic substrate. Hence for a Cu conductor on glass ceramics such as Mg/Al silicates (cordierite)

$$Cu\ K\alpha\ \lambda = 1,542\ \text{Å}\ (0,1542\ \text{nm})$$

$$Al\ K\alpha\ \lambda = 8,338\ \text{Å}\ (0,8338\ \text{nm})$$

therefore,

$$\Delta\lambda = 6,796\ \text{Å}\ (0,6796\ \text{nm}).$$

It is apparent that other combinations of materials and modifications of this invention can be practiced without departing from the essential scope thereof.

**Claims**

1. Method of forming a resist mask over a surface of a dielectric substrate (10) having ahvetallic pattern (12) on said surface, the method comprising the steps of

blanket coating said surface with said resist (14),

exposing said surface to resist-insensitive X-rays that induce resist-sensitive X-ray radiation from portions of said dielectric substrate not masked by said metallic pattern, and

developing said exposed resist for removal of portions only over said metallic pattern to produce a self-aligned resist mask.

2. Method of claim 1, further including the steps of:

blanket coating the resist mask (14) with a metal (20), and

removing said resist mask together with said metal coating thereon while said metal coating on said metallic pattern is retained.

3. Method of claim 1, wherein said dielectric substrate (10) is or contains $Al_2O_3$ and said resist sensitive X-ray radiation is Al-excited X-ray emission.

4. Method of claims 1 and 3 wherein a self-aligned resist mask is formed over the surface of said alumina ceramic substrate (10) having a conductive pattern (12) thereon comprising the steps of

blanket coating said surface with a negative resist (14) sensitive to aluminum-emitted X-rays,

blanket exposuring said substrate with resist-insensitive X-rays to induce X-ray emission by the aluminum in said substrate to penetrate said resist with said aluminum X-ray emission, said aluminum X-ray emission being screened by said conductive pattern on said surface, whereby only said resist adjacent said conductive pattern is penetrated by said aluminum X-ray emission, and

developing said resist for removal thereof of portions over said conductive pattern while retaining said resist doped by said aluminum X-ray emission.

5. Method of claim 4, further comprising the steps of coating said resist mask with a metal (20) and removing said resist with said-metal coating thereon, retaining said metal coating on said conductive pattern (12).

6. Method of claim 2 or 5, wherein said blanket coating of a metal (20) comprises sputter coating.

7. Method of claim 2 or 5, wherein the step of blanket coating a metal (20) comprises vacuum evaporation coating.

8. Method of claim 3 or 4, wherein said metallic or conductive pattern (12) comprises molybdenum.

9. Method of claim 3 or 4, wherein said metallic or conductive pattern comprises copper.

10. Method of claim 1 or 4, wherein said resist is selected from the group consisting of: hydrocarbon resist, brominated tetrathiafulvalene-functionalized poly(styrene), metal acrylates, t-1 poly-(methylmethacrylate-co-methacrylic acid) or poly(methylmethacrylate).

**Patentansprüche**

1. Verfahren zum Herstellen einer Resistmaske auf der Oberfläche eines dielektrischen Substrats (10) mit einem auf besagter Oberfläche befindlichen metallischen Muster (12), das folgende Schritte umfaßt:

ganzflächiges Beschichten der Oberfläche mit dem Resist (14),

Belichten der Oberfläche mit resistunempfindlicher Röntgenstrahlung, wodurch in Teilen des dielektrischen Substrats, die nicht von dem metallischen Muster bedeckt sind, eine resistempfindliche Röntgengstrahlung induziert wird und

Entwickeln des belichteten Resists, um Teile desselben lediglich über dem metallischen Muster zu entfernen, so daß eine selbstjustierte Resistmaske entsteht.

2. Verfahren nach Anspruch 1, das außerdem folgende Schritte umfaßt:

ganzflächiges Beschichten der Resistmaske (14) mit einem Metall (20) und

Entfernen der Resistmaske mit der daraufbefindlichen Metallschicht unter gleichzeitiger Beibehaltung derselben auf dem metallischen Muster.

3. Verfahren nach Anspruch 1, bei dem das dielektrische Substrat (10) aus $Al_2O_3$ besteht oder $Al_2O_3$ enthält, und es sich bei der resistempfindlichen Röntgenstrahlung um eine aluminiumangeregte Röntgenemission handelt.

4. Verfahren nach den Ansprüchen 1 und 3, bei dem eine selbstjustierte Maske auf der Oberfläche des aluminiumoxidkeramischen Substrats (10) mit einem darauf befindlichen Leitungsmuster (12) gebildet wird, das folgende Schritte umfaßt:

ganzflächiges Beschichten der Oberfläche mit einem negativen gegen die aluminiumemittierte Röntgenstrahlung empfindlichen Resist (14),

ganzflächiges Belichten des Substrats mit resistunempfindlicher Röntgenstrahlung, so daß durch das Aluminium in das Substrat eine Röntgenstrahlemission induziert wird, die den Resist mit Aluminiumröntgenstrahlung durchdringt, wobei die durch das Aluminium emittierte Röntgenstrahlung durch das Leitungsmuster auf der Oberfläche abgeschirmt wird, so daß nur der an das Leitungsmuster angrenzende Resist von der aluminumemittierten Röntgenstrahlung durchdrungen wird, und

Entwickeln des Resists, so daß Teile desselben über dem Leitungsmuster entfernt werden, während der durch die aluminiumemittierte Röntgenstrahlung dotierte Resist erhalten bleibt.

5. Verfahren nach Anspruch 4, das außerdem folgende Schritte umfaßt:

Beschichten der Resistmaske mit einem Metall (20) und Entfernen des Resists mit der daraufbefindlichen Metallschicht unter Beibehaltung derselben über dem Leitungsmuster (12).

6. Verfahren nach Anspruch 2 oder 5, wobei es sich bei der ganzflächigen Beschichtung mit Metall (20) um eine Sputterbeschichtung handelt.

7. Verfahren nach Anspruch 2 oder 5, wobei es sich bei der ganzflächigen Beschichtung mit Metall (20) um eine in Vakuum augedampfte Beschichtung handelt.

8. Verfahren nach Anspruch 3 oder 4, wobei das Metalloder Leitungsmuster (12) Molybdän enthält.

9. Verfahren nach Anspruch 3 oder 4, wobei das Metalloder Leitungsmuster Kupfer enthält.

10. Verfahren nach Anspruch 1 oder 4, wobei der Resist aus der Gruppe von Kohlenwasserstofresist, bromiertem tetrathiofulvalenfunktionalisiertem Poly(styrol), Metallacrylaten, t-1 Poly(methylmethacrylat-co-methacrylsäure) oder Poly(methylmethacrylat) besteht.

**Revendications**

1. Procédé pour former un masque de résine photosensible sur une surface d'un substrat diélectrique (19) possédant une structure métallique (12) sur ladite surface, ce procédé incluant les étapes consistant à:

déposer sur ladite surface un revêtement enveloppant formé par ladite résine (14),

exposer ladite surface à des rayons, auxquels est insensible la résine et qui induisent un rayonnement X, auquel est sensible la résine, à partir dudit substrat diélectrique non masqué par ladite structure métallique, et développer ladite résine exposée pour éliminer des parties situées uniquement sur ladite structure métallique afin de former un masque de résine autoaligné.

2. Procédé selon la revendication 1, incluant en outre les étapes consistant à:

déposer sur le masque de résine (14) un revêtement enveloppant constitué par un métal (20), et

éliminer ledit masque de résine ainsi que ledit revêtement métallique situé sur ce masque, tout en conservant ledit revêtement métallique sur ladite structure métallique.

3. Procédé selon la revendication 1, selon lequel ledit substrat diélectrique (10) est ou contient du Al₂O₃ et ledit rayonnement, auquel est sensible la résine, est une émission de rayons X excités par le Al.

4. Procédé selon les revendications 1 et 3, selon lequel on forme un masque de résine autoaligné sur la surface dudit substrat céramique en alumine (10), qui porte une structure conductrice (12), incluant les étapes consistant à:

déposer sur ladite surface un revêtement enveloppant formé par une résine à effet négatif (14), sensible aux rayons X émis par l'aluminium,

exposer l'ensemble dudit substrat à des rayons X, auxquels la résine est insensible, pour induire une émission de rayons X par l'aluminium dans ledit substrat de manière que lesdits rayons X émis par l'aluminium travers ladite résine, ladite émission de rayons X par l'aluminium étant occultée par ladite structure conductrice située sur ladite surface, ce qui a pour effet que seule ladite résine adjacente à ladite structure conductrice est traversée par lesdits rayons X émis par l'aluminium, et

développer ladite résine pour en éliminer des parties situées au-dessus de ladite structure conductrice, tout en conservant ladite résine dopée au moyen de ladite émission de rayons X par l'aluminium.

5. Procédé selon la revendication 4, incluant en outre les étapes consistant à recouvrir ledit masque de résine avec un métal (20) et éliminer ladite résine portant ledit revêtement métallique, tout en conservant ledit revêtement métallique sur ladite structure conductrice (12).

6. Procédé selon la revendication 2 ou 5, selon lequel ledit revêtement formé d'un métal (20) est une revêtement déposé par pulvérisation.

7. Procédé selon la revendication 2 ou 5, selon lequel ledit revêtement formé d'un métal (20) est une revêtement dépose par évaporation sous vide.

8. Procédé selon la revendication 3 ou 4, selon lequel ladite structure métallique ou conductrice (12) est formée de molybdène.

9. Procédé selon la revendication 3 ou 4, selon lequel ladite structure métallique ou conductrice est formée de cuivre.

10. Procédé selon la revendication 1 ou 4, selon lequel ladite résine est choisie parmi le groupe incluant:

une résine à base d'hydrocarbures, du polystyrène bromé fonctionnalisé par du tétrathiafulvalène, des acrylates métalliques, de l'acide t-1 polyméthylméthacrylate-cométhacrylique ou de polyméthylméthacrylate.

FIG.IA

FIG.IB

FIG.IC

FIG.ID

FIG.IE